Europäisches Patentamt

European Patent Office

Office européen des brevets

(11) Publication number: 0 316 562
A2

## (12) EUROPEAN PATENT APPLICATION

(21) Application number: 88116459.4

(22) Date of filing: 05.10.88

(51) Int. Cl.4: H01L 29/08 , H01L 29/72

(30) Priority: 19.11.87 US 121204

(43) Date of publication of application:
24.05.89 Bulletin 89/21

(84) Designated Contracting States:
DE FR GB IT NL

(71) Applicant: TEXAS INSTRUMENTS
INCORPORATED
13500 North Central Expressway
Dallas Texas 75265(US)

(72) Inventor: Mosher, Dan M.
3521 Wandering Trail
Plano Texas 75075(US)
Inventor: Trogolo, Joe R.
2712 Glen Forest Lane
Plano Texas 75075(US)

(74) Representative: Leiser, Gottfried, Dipl.-Ing. et
al
Patentanwälte Prinz, Leiser, Bunke & Partner
Manzingerweg 7
D-8000 München 60(DE)

(54) Semiconductor bipolar transistors with base and emitter structures in a trench and process to produce same.

(57) The disclosure relates to an integrated circuit substrate having a bipolar transistor wherein the base (25) and emitter (27) regions are disposed in a first trench in the substrate (5) and the collector (29) is disposed in the substrate spaced from the trench. The collector is preferably a second trench. The trenches are filled with doped polysilicon (31,33) wherein the dopant has diffused in part into the side walls of the trenches. The method of forming the integrated circuit comprises the steps of providing a semiconductor substrate (5) of predetermined conductivity type (N), forming a shallow region (15) of opposite type (P) conductivity in the substrate, forming a trench in the substrate extending through the shallow region, forming base (25) and emitter (27) regions in the trench and forming a collector region (29) in the substrate (5) spaced from the trench.

Fig.7a

EP 0 316 562 A2

# SEMICONDUCTOR BIPOLAR TRANSISTORS WITH BASE AND EMITTER STRUCTURES IN A TRENCH AND PROCESS TO PRODUCE SAME

## BACKGROUND OF THE INVENTION

### FIELD OF THE INVENTION

This invention relates to bipolar transistors and the manufacture thereof in integrated circuits and, more specific ally, to the formation of such bipolar devices in a trench.

### BRIEF DESCRIPTION OF THE PRIOR ART

Some integrated circuit applications require multiple current outputs that are independent of one another. However, it is difficult to obtain high currents with such designs. The standard manner to overcome this problem, where multiple outputs are required, has been to bring the outputs to the front side of the chip along with the inputs as set forth, for example, in "Power Devices are in the Chips, by Vladimir Rumennek, IEEE Spectrum, July 1985, pp. 42-48. The performance obtained from such devices has been far inferior to that obtained from individual bipolar devices. The reason for this poor performance is that this standard solution provides poor area efficiency and poor collector resistance characteristics.

In order to overcome this limitation, it is possible to fabricate devices with current flow vertically from the front side to the back side of the chip with the collectors all being disposed on the back side. However, with this arrangement, all of the collectors are connected together on the chip back side, thereby preventing the formation of some forms of multiple outputs. To attempt to separate outputs in such vertical design is not compatible with integrated circuit processing techniques since operation on the wafer back side presents fabrication problems.

To improve collector resistance in such prior art bipolar transistors having a front side output, a highly doped layer is added as a buried layer before the epitaxial layer is grown and a deep, highly doped region is added to the surface at the collector contact to penetrate all the way down to the N + buried layer. In this manner, it is possible to reduce the collector resistance, but not as a value as low as that obtainable with a vertical design.

To improve the area efficiency of the prior art bipolar transistor having a front side output, the area occupied by the transistor at the front side surface can be increased. However, this provides only limited improvement.

It is therefore clear from the above description of the prior art that the problem of providing an integrated circuit composed of bipolar transistors with multiple high current outputs has not been adequately solved at this time.

## SUMMARY OF THE INVENTION

In accordance with the present invention, the above noted problems of the prior art are overcome and the performance advantages of the standard vertical bipolar transistor design are provided while still being integrable with other isolated devices on a single chip, such as CMOS, bipolar logic, etc. This invention directly addresses the major limitation of present technologies, namely, the current handling capability of devices integrated on the same chip with logic functions and creates a process whereby the emitter area is potentially increased to greater than the area of the chip.

Briefly, the above is accomplished by forming the base and emitter of a bipolar transistor in a single trench etched into the semiconductor surface. This is accomplished by providing a base diffusion and emitter diffusion into the silicon in that trench. When the structure is biased as a transistor, the current flow is lateral to another surface contact or another trench and results in a very short current path to provide very low resistance in the current path. Placing the base and emitter in the trench also allows the possibility that the area of the base and emitter, due to the trench, actually be larger (have greater area) than the surface of the chip itself, providing a higher current capability for a given size chip.

The process includes forming an oxide mask on a p-type semiconductor substrate and forming a buried n region therein. Further semiconductor processing is essentially over the buried layer. The oxide is removed and an n-type epitaxial layer of silicon is formed over the substrate. An oxide layer is then formed thereover, patterned in the field regions whereat isolation is to be provided and p-type impurity is is deposited therein extending to the substrate. The epitaxial layer surface is again covered with oxide and regions whereat the emitter and base are to be formed are patterned, the oxide removed and a p+ region is formed at the surface of the epitaxial layer. The exposed epitaxial region is again oxidised and the substrate surface is patterned and etched at regions where trenches are to be formed. The trenches will extend through the p + regions as well as in other regions whereat trenches will be required, such as for isolation in place of the above described isolation technique or the like. Next, a layer of polycrystalline silicon (polysilicon) is formed over the substrate and partially into the trench and against the sidewalls therein. An oxide is deposited on the surface of the substrate and patterned to expose only those trenches wherein base and emitter regions are to be formed. A p + impurity is now diffused into the open trench sidewalls and bottom.

The deposited oxide is now stripped off and an n-type dopant is deposited over the polysilicon and a further layer of polysilicon is deposited thereover to fill the trenches and provide a relatively flat polysilicon surface. The n-type dopant diffuses through the polysilicon as well as a short distance into the trench sidewalls. The polysilicon is then etched away except over the trenches and p + regions originally formed. The transistors are completed by forming an oxide layer over the substrate, patterning the oxide to provide apertures for metallization to base, emitter and collector with subsequent metallization and passivation with a layer of silicon nitride over the substrate surface.

The result of the above is an integrated circuit having plural bipolar transistors therein on a single chip wherein all of the collector electrodes are on the front side of the chip. In addition, emitter and base are formed in a single trench to provide a very short current path with concomitant low resistance therein as well as a base and emitter area larger than the chip surface.

## BRIEF DESCRIPTION OF THE DRAWINGS

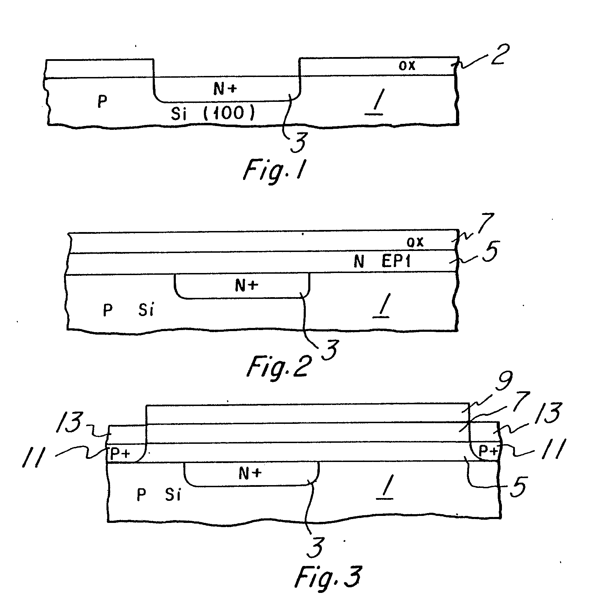

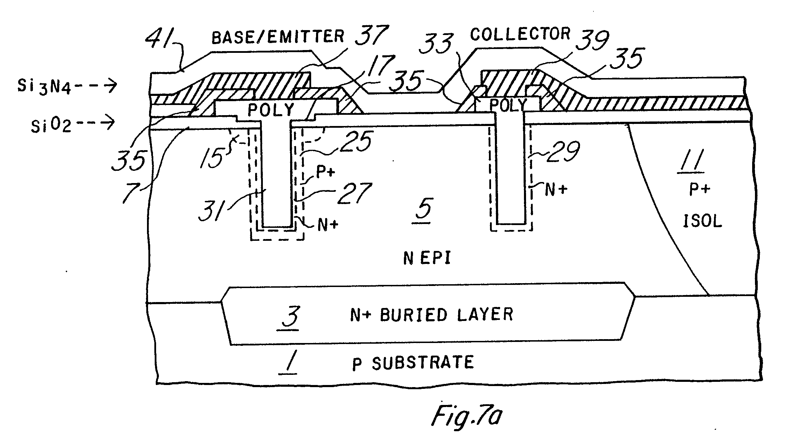

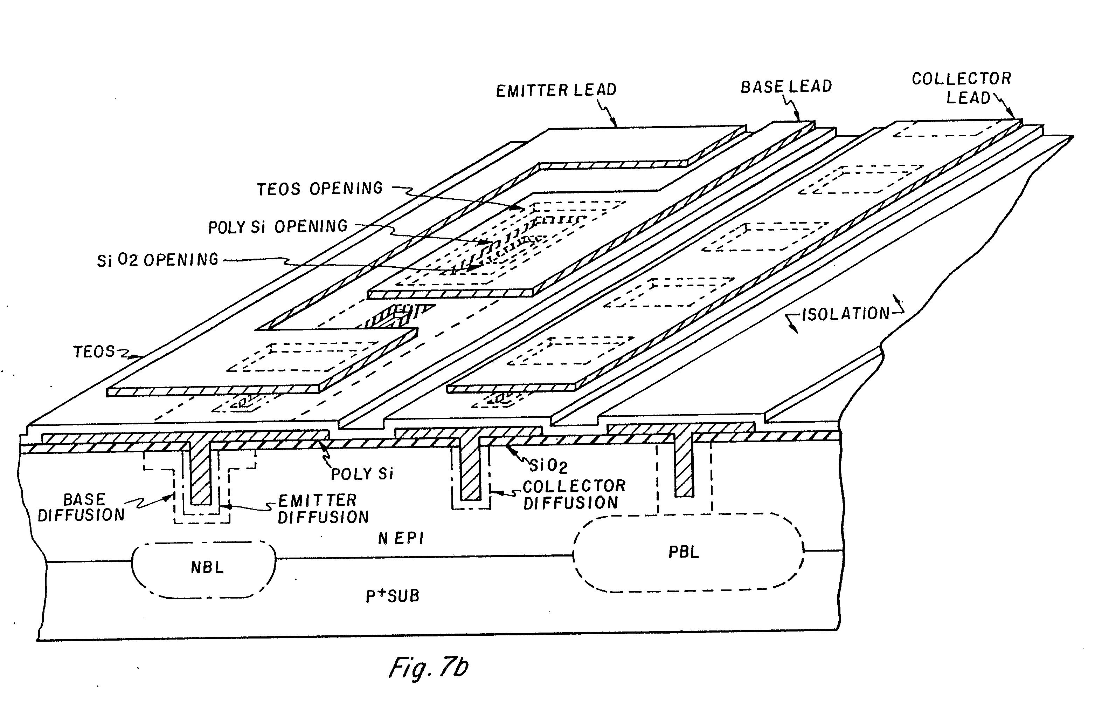

FIGURES 1 to 7 are schematic drawings showing the device being constructed at various stages in the process flow in accordance with the present invention as well as the final device shown in cross section in FIGURE 7a and top view in FIGURE 7b.

## DESCRIPTION OF THE PREFERRED EMBODIMENT

A preferred method for forming a bipolar transistor in accordance with the present invention will now be described in detail. Referring to FIGURE 1, there is shown a silicon sub strate 1 with (100) crystallographic orientation which has been doped with p-type impurity to a resistivity of 10 to 20 ohm-centimeters. The surface of the substrate 1 is oxidized in steam at 1100 degrees C. to provide an oxide layer 2 to a depth of about 6500 Angstroms.

A pattern is defined thereon photolithographically for the N buried layer 3 using a photoresist and the oxide is etched away out of the patterned areas. A light $5 \times 10^{12}$ dose of n-type dopant is then implanted and diffused into the the exposed patterned area on the substrate 1 to provide the buried layer 3. The use of low concentration doping at this point is different from normal processing because the purpose of this buried layer is different in this structure than in processes to form prior art planar bipolar transistors. The dopant is diffused 10 micrometers into the substrate.

The oxide layer is then stripped from the substrate by standard etching and 15 micrometers of lightly doped (about 5 ohm-cm) n-type silicon 5 is epitaxially deposited on the substrate surface. The epitaxial layer is oxidized to form an oxide layer 7 as shown in FIGURE 2. A pattern 9 is then photolithographically defined on the oxide layer 7 with photoresist to define a pattern to isolate adjacent tanks or area wherein devices will be formed from each other and the oxide is etched away in the patterned areas. The photoresist 9 is removed. The exposed areas of the epitaxial layer 5 are then thermally doped with a high concentration of boron to a sheet resistance of 5 ohms per square and the boron is diffused deeply enough so that it penetrates the epitaxial layer and forms a continuous p-type region 11 from the surface of the substrate to the outer surface of the epitaxial layer 5 as shown in FIGURE 3. The exposed areas are covered by growing an oxide layer 13 thereon during this diffusion.

A base 1 pattern is now defined by patterning the oxide layer 7 with photoresist, etching away the silicon oxide in the exposed area and then forming shallow regions about 2 micrometers deep of p + doping 15 into the exposed epitaxial layer 5 using thermal source deposition and a short diffusion to obtain the shallow, low resistivity (about 100 ohms/sq.) p-type diffused area. This structure is unique to this technology and will be used to act as an electrical buss between the contacts to base and active base areas which will be defined subsequently in the procedure. An oxide layer 17 is then grown on the exposed silicon during the diffusion.

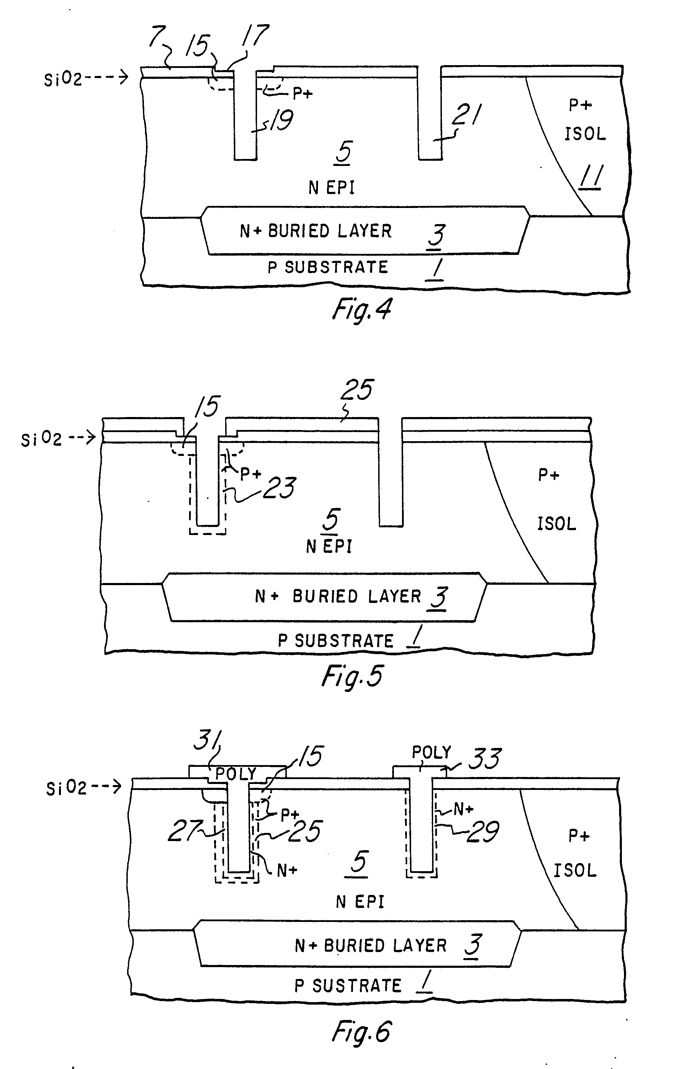

The trench pattern is now photolithographically defined with photoresist and the exposed oxide is etched away. Using a reactive ion etching technique, the silicon is then removed to a depth of 10 micrometers to form trenches 19 and 21. The structure at this point in the procedure is shown in FIGURE 4. It can be seen that some of the trenches 19 may pass through the p + regions 15 whereas other trenches 21 may not. The trenches which will contain base and emitter diffusions will pass through the previously formed p + region.

A 5000 Angstrom thick layer of polysilicon is then conformally deposited on the entire surface of the chip and into both of the trenches and along the trench walls to partially fill the trenches.

Any trenches in which base and emitter diffusions will not be provided are now sealed off, such as by conformally depositing a layer of silicon oxide and/or silicon nitride 25 over the surface of the chip of sufficient thickness to close the trenches 19 and 21, masking the surface of the chip with standard photolithograhic techniques to expose the seal on the trench 19 to be opened wherein diffusion is to take place with subsequent etching of the sealing material in the trench 19 in which diffusion will take place by standard etching techniques to open that trench wherein diffusion is to take place. A p + region 23 is now diffused into the trench area by thermal boron deposition to form a p + layer around the walls of the trench 19 with the other trench 21 having no diffusions therein at this time, to provide the active base regions of the transistors in the wall of the trench 19 to provide the structure as shown in FIGURE 5. The remaining silicon oxide and/or silicon nitride shield material 25 is now removed from the surface of the chip by standard etching techniques.

N-type dopant, such as phosphorus, is then thermally deposited on the polysilicon and another 8000 Angstrom layer of polysilicon is deposited thereover to close up the trenches. A diffusion cycle is now provided by heating to a temperature of 1000 degrees C. for 20 minutes to drive the phosphorus evenly into the polysilicon and a short distance into the crystalline silicon at 27 of the layer 5 to provide base and emitter regions in the trench 19 and an n + region 29 which acts as a contact to the n-type epitaxial layer 5 in the other trench 21. The polysilicon 31 and 33 is then photolithographically patterned and etched away except over the trenches, the p + region at the surface of the layer 5 and slightly therebeyond and any other locations where it might be required to provide the structure as shown in FIGURE 6. It can be seen that an NPN transistor has been formed with the n + region 27 in the first trench 19 being the emitter, the p + region 25 being the base and the n + region in the second trench 21 being the collector.

A 1 micrometer layer of silicon oxide 35 is then deposited over the entire chip, photolithographically patterned and etched to insulate the polysilicon 31 and 33 from the metal to be applied later. The silicon oxide may also be left in other areas for field relief or other reasons. Openings in the silicon oxide layer are then formed by patterning and etching for contacts to the base and isolation regions. Metallization in the form of a 2 micrometer layer of aluminum 37 and 39 is then deposited and patterned by appropriate photolithograhy and etching to contact the exposed polysilicon 31 and 33 and form leads and bond pads. A 1 micrometer layer of silicon nitride 41 is then deposited over the entire chip surface for passiviation. This layer is patterned and etched to open the bond pads and the metal is sintered. This completes the processing to provide the structure as shown in FIGURES 7a and 7b.

There are several possible variations on the above described structure and process that are within the scope of the disclosure. They differ in structure as follows: A p-type buried layer and a trench can be used with p-type doping to form the isolation, in place of the deep p + diffusion specified in the above description. A second variation eliminates the collector trench and uses only a shallow n + contact to the epitaxial layer for the collector. These two structures require somewhat different processing than specified above, with the first variation being more complex and the second being simpler. Another possible variation achieves isolation with a layer of silicon dioxide created below the surface of the slice by implantation and anneal of oxygen before the epitaxial layer is deposited. Trenches are etched through the epitaxial layer down to the oxide and the sidewalls are oxidized, thereby creating a totally oxide isolated silicon region for the device. In addition to these particular variations, this disclosure antici pates and includes any structure and process which results in the active base and emitter regions of a bipolar transistor being formed in the walls of a trench in a semiconductor surface in any manner similar to that described hereinabove.

Though the invention has been described with respect to a specific preferred embodiment thereof, many variations and modifications will immediately become apparent to those skilled in the art. It is therefore the intention that the appended claims be interpreted as broadly as possible in view of the prior art to include all such variations and modifications.

**Claims**

1. A bipolar transistor comprising:
    (a) a semiconductor substrate having a top surface of predetermined conductivity type;
    (b) a first trench formed in said substrate;
    (c) an emitter region in said first trench of said predetermined conductivity type;
    (d) a base region in said substrate surrounding said first trench of opposite conductivity type;
    (e) a collector region in said substrate of said predeter mined conductivity type spaced from said base region; and

(f) contacts to each of said emitter, base and collector regions.

2. A transistor as set forth in claim 1, wherein said substrate includes an epitaxial layer thereon of opposite conductivity type as said substrate, said epitaxial layer including said top surface.

3. A transistor as set forth in claim 2 wherein said emitter region extends into the side walls of said first trench.

4. A transistor as set forth in claim 2, further including predetermined type conductivity doped polysilicon in said first trench forming said emitter region.

5. A transistor as set forth in claim 3, further including predetermined type conductivity doped polysilicon in said first trench forming said emitter region.

6. A transistor as set forth in claim 2 wherein said collector region comprises a second trench in said substrate spaced from said first trench, said collector region extending into the side walls of said second trench.

7. A transistor as set forth in claim 6, wherein said collector region further includes predetermined type conductivity doped polysilicon therein.

8. A transistor as set forth in claim 3 wherein said collector region comprises a second trench in said substrate spaced from said first trench, said collector region extending into the side walls of said second trench.

9. A transistor as set forth in claim 8, wherein said collector region further includes predetermined type conductivity doped polysilicon therein.

10. A transistor as set forth in claim 4 wherein said collector region comprises a second trench in said substrate spaced from said first trench, said collector region extending into the side walls of said second trench.

11. A transistor as set forth in claim 10, wherein said collector region further includes predetermined type conductivity doped polysilicon therein.

12. A transistor as set forth in claim 5 wherein said collector region comprises a second trench in said substrate spaced from said first trench, said collector region extending into the side walls of said second trench.

13. A transistor as set forth in claim 12, wherein said collector region further includes predetermined type conductivity doped polysilicon therein.

14. An integrated circuit comprising:

(a) a semiconductor substrate having a top surface of a predetermined conductivity type; and

(b) a plurality of bipolar transistors in said substrate, each transistor comprising:

(c) a first trench formed in said substrate;

(d) an emitter region in said first trench of said predetermined conductivity type;

(e) a base region in said substrate surrounding said first trench of opposite conductivity type;

(f) a collector region in said substrate of said predeter mined conductivity type spaced from said base region; and

(g) contacts to each of said emitter, base and collector regions.

15. An integrated circuit as set forth in claim 14 wherein said substrate includes an epitaxial layer thereon of opposite conductivity type as said substrate, said epitaxial layer including said top surface.

16. An integrated circuit as set forth in claim 15 wherein said emitter region extends into the side walls of said first trench.

17. An integrated circuit as set forth in claim 15, further including predetermined type conductivity doped polysilicon in said first trench forming said emitter region.

18. An integrated circuit as set forth in claim 16, further including predetermined type conductivity doped polysilicon in said first trench forming said emitter region.

19. A semiconductor device comprising:

(a) a substrate of predetermined conductivity type having a trench formed therein;

(b) a bipolar transistor in said substrate having electron emitting and control regions disposed within said trench; and

(c) an electron collecting region in said substrate spaced from said trench.

20. A method of forming a bipolar transistor, comprising the steps of:

(a) providing a semiconductor substrate having a top surface of a predetermined conductivity type;

(b) forming a shallow region of opposite type conductivity in said substrate;

(c) forming a trench in said substrate extending through said shallow region;

(d) forming base and emitter regions in said trench; and

(e) forming a collector region in said substrate spaced from said trench.

21. The method of claim 20 wherein said substrate includes an epitaxial layer thereon of opposite conductivity type as said substrate, said epitaxial layer including said top surface.

22. The method of claim 21 wherein said step of forming base and emitter regions comprises depositing a dopant of opposite conductivity type into said trench and then depositing a dopant of said predetermined conductivity type into said trench.

23. The method of claim 22 wherein said step of depositing said last mentioned dopant of predetermined conductivity type includes filling said trench with polysilicon containing a dopant of said predetermined conductivity type and permitting said dopant to diffuse from said polysilicon into the side walls of said trench.

24. The method of claim 21 wherein said step of forming said collector region comprises forming a second trench and depositing a dopant of said predetermined conductivity type into said trench.

25. The method of claim 24 wherein said step of depositing said dopant into said saecond trench includes filling said second trench with polysilicon containing a dopant of said predetermined conductivity type and permitting said dopant to diffuse from said polysilicon into the side walls of said second trench.

26. The method of claim 22 wherein said step of forming said collector region comprises forming a second trench and depositing a dopant of said predetermined conductivity type into said trench.

27. The method of claim 26 wherein said step of depositing said dopant into said saecond trench incudes filling said second trench with polysilicon containing a dopant of said predetermined conductivity type and permitting said dopant to diffuse from said polysilicon into the side walls of said second trench.

28. The method of claim 23 wherein said step of forming said collector region comprises forming a second trench and depositing a dopant of said predetermined conductivity type into said trench.

29. The method of claim 28 wherein said step of depositing said dopant into said second trench includes filling said second trench with polysilicon containing a dopant of said predetermined conductivity type and permitting said dopant to diffuse from said polysilicon into the side walls of said second trench.

Fig. 1

Fig. 2

Fig. 3

EP 0 316 562 A2

SiO2 ---→ *7* *15* *17*

P+

*19*

*21*

P+
ISOL

*5*
N EPI

*11*

N+ BURIED LAYER *3*

P SUBSTRATE *1*

*Fig.4*

SiO2 --→ *15* *25*

P+ *23*

*5*
N EPI

P+
ISOL

N+ BURIED LAYER *3*

P SUBSTRATE *1*

*Fig.5*

*31* POLY *15* POLY *33*

SiO2 →

*27* P+ *25* N+ *29*

N+

*5*

N EPI

P+
ISOL

N+ BURIED LAYER *3*

P SUSTRATE *1*

*Fig.6*

Fig.7a

EP 0 316 562 A2

COLLECTOR LEAD

BASE LEAD

EMITTER LEAD

ISOLATION

TEOS OPENING

POLY Si OPENING

Si O2 OPENING

TEOS

POLY Si

SiO2

COLLECTOR DIFFUSION

EMITTER DIFFUSION

BASE DIFFUSION

PBL

NBL

N EPI

P⁺SUB

Fig. 7b